# EUROPEAN PATENT APPLICATION

(11) **EP 4 844 385 A1**
(43) Date of publication of application: **25.11.2026**
(21) Application number: 26162281.5
(22) Date of filing: 04.03.2026
(51) Int. Cl.: G01N 21/95, G01N 21/88, G01N 21/31, G01B 11/02, G03F 7/00, H10P 74/20

(54) **OPTICAL SYSTEM FOR METROLOGY AND INSPECTION, METROLOGY AND INSPECTION APPARATUS INCLUDING THE SAME, AND METROLOGY AND INSPECTION METHOD**

(30) Priority: 21.05.2025 KR 20250066418
(71) Applicant: Samsung Electronics Co., Ltd., Suwon-si, Gyeonggi-do 16677 (KR)
(72) Inventor: PARK, Junghyun, 16678 Suwon-si (KR); HAN, Seunghoon, 16677 Suwon-si (KR)
(74) Representative: Elkington and Fife LLP

(57) **Abstract**

Provided is an optical system for metrology and inspection, the optical system including a substrate including a first surface and a second surface facing the first surface, a light source configured to emit light toward the first surface of the substrate with respect to a subject on the second surface of the substrate, an incidence angle adjuster on the first surface of the substrate, and a photodetector configured to detect light having passed through the substrate and the subject and emitted through the first surface of the substrate, wherein a wavenumber of light incident on the substrate is greater than a transverse wavenumber corresponding to a total reflection condition of air and a total reflection condition of the substrate, and is less than a transverse wavenumber corresponding to the total reflection condition of the substrate and a total reflection condition of the subject.

## Description

### FIELD OF THE INVENTION

Embodiments of the present disclosure relate to an optical system for metrology and inspection capable of increasing a signal-to-noise ratio (SNR), a metrology and inspection apparatus including the same, and a metrology and inspection method.

### BACKGROUND OF THE INVENTION

Recently, semiconductor devices have been developed into a three-dimensional (3D) nanostructure in which a plurality of semiconductor layers are stacked in a vertical direction for high integration. In such 3D semiconductor devices, through-silicon vias (TSVs), metal wirings, insulating layers, etc., are complexly stacked, and thus it is important to measure and inspect defects that may occur during a manufacturing process. Metrology and inspection of semiconductor devices are mainly performed by emitting light toward the surface of a subject and analyzing reflected and/or diffracted light. However, according to such an optical illuminating method, the transmission depth of light is limited by an increase in the overall height of the 3D nanostructure, which makes it difficult to perform metrology and inspection on a deep portion of a semiconductor device.

### SUMMARY OF THE INVENTION

One or more embodiments provide an optical system for metrology and inspection in a three-dimensional (3D) nanostructure capable of increasing a signal-to-noise ratio (SNR) of a metrology signal by increasing a path length of light passing through a subject.

One or more embodiments also provide a metrology and inspection apparatus including an optical system for metrology and inspection in a 3D nanostructure capable of increasing an SNR of a metrology signal by increasing a path length of light passing through a subject.

One or more embodiments also provide a metrology and inspection method in a 3D nanostructure capable of increasing an SNR of a metrology signal by increasing a path length of light passing through a subject.

Additional aspects will be set forth in part in the description which follows and, in part, will be apparent from the description, or may be learned by practice of one or more embodiments.

According to an aspect of one or more embodiments, there is provided an optical system for metrology and inspection, the optical system including a substrate including a first surface and a second surface facing the first surface, a light source configured to emit light toward the first surface of the substrate with respect to a subject on the second surface of the substrate, an incidence angle adjuster on the first surface of the substrate, and a photodetector configured to detect light having passed through the substrate and the subject and emitted through the first surface of the substrate, wherein a wavenumber of light incident on the substrate is greater than a transverse wavenumber corresponding to a total reflection condition of air and a total reflection condition of the substrate, and is less than a transverse wavenumber corresponding to the total reflection condition of the substrate and a total reflection condition of the subject.

Proposed embodiments concern an optical metrology and inspection system for three-dimensional nanostructures, particularly semiconductor devices, which increases metrological sensitivity by deliberately extending the optical path length within the structure under test. A proposed concept is to control the transverse wavenumber (i.e. incidence angle within a high-index substrate) such that light enters the subject but is totally internally reflected at the subject-air interface, thereby maximising interaction with deep structural features and improving signal-to-noise ratio (SNR).

Proposed is the use of an incidence angle adjuster (for example a prism or immersion lens arrangement) on the rear surface of the substrate to engineer the angular spectrum of the illumination. Embodiments may be configured so that the transverse wavenumber of the incident light lies between the total internal reflection condition at the substrate-air interface and that at the substrate-subject interface. This ensures that light couples efficiently into the subject from the substrate but cannot escape into air, instead undergoing total internal reflection at the upper surface of the subject and traversing the subject multiple times. Described examples provide physical framework for this condition, expressed in terms of refractive indices and incidence angles, with a worked example demonstrating an optimal angular window for silicon/SiO₂ systems.

Functionally, the increased optical path length through the subject may lead to enhanced sensitivity of spectroscopic and polarimetric measurements, such as Mueller matrix ellipsometry and optical critical dimension (OCD) metrology. Simulations have demonstrated a substantial increase in spectral separability and predictive accuracy for small structural variations in deep 3D devices, compared with conventional front-side illumination approaches. The proposed concept(s) may be particularly well suited to high-aspect-ratio and vertically stacked structures (e.g. VNAND, DRAM, waveguide couplers), where conventional illumination suffers from limited penetration depth and poor SNR.

From an implementation perspective, embodiments may be attractive in that they may rely on relatively simple optical components (prisms, lenses, immersion media) integrated on the rear surface of an otherwise conventional substrate, without requiring modification of the subject itself. This may facilitate integration into existing metrology platforms and back-side inspection workflows. The same underlying optical concept may be consistently extended across system, apparatus, and method aspects, and centred on control of the transverse wavenumber regime.

A refractive index of the substrate may be greater than an effective refractive index of the subject, and the effective refractive index of the subject may be greater than 1.

The incidence angle adjuster may include a prism, and a refractive index of the prism may be less than the refractive index of the substrate.

The incidence angle adjuster may be configured such that an incidence angle θ₁ of light incident on the subject from the substrate satisfies 16.6° < θ₁ < 24.6°.

The incidence angle adjuster may include a prism, and a refractive index of the prism is greater than or equal to 1.4 less than or equal to 1.8.

The prism may include at least one of borosilicate crown glass, molten silica, flint glass, or calcium fluoride (CaF₂).

An apex angle of the prism may be greater than or equal to 10 degrees and less than or equal to 45.

The incidence angle adjuster may include a lens and an immersion medium included in the lens.

A refractive index of the immersion medium may be greater than or equal to 1.2 and less than or equal to 1.7.

A point where light is incident on the incidence angle adjuster may be different from a point where light reflected from the subject passes through the incidence angle adjuster.

According to another aspect of one or more embodiments, there is provided a metrology and inspection apparatus including a substrate including a first surface and a second surface facing the first surface, a light source configured to emit light toward the first surface of the substrate with respect to a subject on the second surface of the substrate, an incidence angle adjuster on the first surface of the substrate, a photodetector configured to detect light having passed through the substrate and the subject and emitted through the first surface of the substrate, and a processor configured to control an operation of the light source and the photodetector and, based on an output of the photodetector, analyze the subject, wherein a wavenumber of light incident on the substrate is greater than a transverse wavenumber corresponding to a total reflection condition of air and a total reflection condition of the substrate, and is less than a transverse wavenumber corresponding to the total reflection condition of the substrate and a total reflection condition of the subject.

A refractive index of the substrate may be greater than an effective refractive index of the subject, and the effective refractive index of the subject is greater than 1.

The incidence angle adjuster may include a prism, and a refractive index of the prism may be less than the refractive index of the substrate.

The incidence angle adjuster may be configured such that an incidence angle θ₁ of light incident on the subject from the substrate satisfies 16.6° < θ₁ < 24.6°.

The metrology and inspection apparatus may further include a first polarization filter between the light source and the incidence angle adjuster.

The metrology and inspection apparatus may further include a second polarization filter between the incidence angle adjuster and the photodetector.

The incidence angle adjuster may include a lens and an immersion medium included in the lens.

According to still another aspect of one or more embodiments, there is provided A metrology and inspection method on a target object including a substrate including a first surface and a second surface facing the first surface and a subject on the second surface of the substrate, the metrology and inspection method including emitting light by the light source to an incidence angle adjuster, transmitting light, having passed through the incidence angle adjuster, through the substrate and a subject, totally reflecting the light, transmitted through the substrate and the subject, from a surface of the subject, transmitting the light, totally reflected, through the subject, the substrate, and the incidence angle adjuster and be incident on the photodetector, obtaining a Mueller spectrum based on an optical signal incident on the photodetector, and estimating a structure of the subject based on the Mueller spectrum.

A refractive index of the substrate may be greater than an effective refractive index of the subject, and the effective refractive index of the subject may be greater than 1.

The incidence angle adjuster may include a prism, and a refractive index of the prism is less than the refractive index of the substrate.

### BRIEF DESCRIPTION OF DRAWINGS

The above and other aspects, features, and advantages of embodiments of the disclosure will be more apparent from the following description taken in conjunction with the accompanying drawings, in which:
FIG. 1 schematically illustrates an optical system for metrology and inspection, according to one or more embodiments;
FIG. 2 illustrates an example of changing an incidence angle adjuster in an optical system for metrology and inspection, according to one or more embodiments;
FIGS. 3 and 4 illustrate examples of a target object;
FIG. 5A illustrates a metrology and inspection apparatus according to one or more embodiments;
FIG. 5B illustrates a metrology and inspection apparatus according to one or more other embodiments;
FIG. 6 is a diagram for explaining a metrology and inspection method according to one or more embodiments;
FIG. 7 shows that when light passes through two media having different refractive indices, light is reflected and light is refracted at a boundary between the two media;
FIG. 8A illustrates an incidence angle, a refraction, and a reflection path of light in an optical system for metrology and inspection, according to one or more embodiments;
FIG. 8B illustrates an incidence angle, a refraction, and a reflection path of light in an optical device of a related example;
FIG. 9A illustrates the Mueller spectrum of an optical system for metrology and inspection, according to one or more embodiments;
FIG. 9B illustrates a Mueller spectrum of a related example without an incidence angle adjuster;
FIG. 10A illustrates the sum of differences in spectra according to a change in a metrology object shown in FIG. 9A with respect to various incidence angles and azimuthal angles;
FIG. 10B illustrates the sum of differences in spectra according to a change in a metrology object shown in FIG. 9B with respect to various incidence angles and azimuthal angles; and
FIGS. 11A and 11B show a comparison of results of testing whether predictive power or metrological power is actually improved in a relatively high-scale period, assuming that there is noise in a Mueller spectrum with respect to one or more embodiments and a related example, respectively.

### DETAILED DESCRIPTION

Reference will now be made in detail to embodiments, examples of which are shown in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, with reference to the accompanying drawings, an optical system for metrology and inspection, a metrology and inspection apparatus including the same, and a metrology and inspection method will be described in detail. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being disposed on a substrate or another layer, the material layer may be in contact with the other layer, or there may be a third layer between the material layer and the other layer. In the following embodiments, materials constituting each layer are provided merely as an example, and other materials may also be used.

In addition, terms such as "unit" and "module" described in the specification mean a unit that processes at least one function or operation, and this may be implemented as hardware or software, or may be implemented as a combination of hardware and software.

For the purposes of the present disclosure, the term "wavenumber" refers to the magnitude of the optical wavevector k in a given medium, defined as *k* = *2πn*/*λ₀,* where *n* is the refractive index of the medium and *λ₀* is the wavelength in vacuum.

The term "transverse wavenumber" refers to the component of the wavevector parallel to an interface between two media (i.e. perpendicular to the surface normal), which is conserved across the interface. For light propagating in a medium of refractive index *n* at an incidence angle *θ* relative to the surface normal, the transverse wavenumber is given by *kₜ = (2π*/*λ₀)·n·sin θ.*

Accordingly, references in the present disclosure to a "wavenumber of light incident on the substrate" are to be understood as referring specifically to the transverse wavenumber component of that light, unless stated otherwise.

In the present disclosure, a "total reflection condition" between two media is satisfied when the transverse wavenumber of light exceeds the maximum transverse wavenumber supported by propagation in the lower-index medium, such that the light undergoes total internal reflection at the interface.

Thus: the total reflection condition between the substrate and air corresponds to *kₜ > (2π*/*λ₀)·n₀,* and the total reflection condition between the substrate and the subject corresponds to *kₜ > (2π*/*λ₀)·n₂,* where *n₀* is the refractive index of air and *n₂* is the effective refractive index of the subject.

Where the subject comprises a heterogeneous three-dimensional structure including multiple materials, the effective refractive index of the subject is defined, for the purposes of determining optical boundary conditions, as a representative refractive index characterising the dominant optical response of the subject. In example implementations, this may correspond to the refractive index of the material occupying the largest volume fraction of the subject, or another material that predominantly governs optical propagation within the subject over the wavelength range of interest.

The specific implementations described in the embodiment are examples and are not intended to limit the technical scope in any way. For the sake of brevity of the specification, descriptions of conventional electronic components, control systems, software, and other functional aspects of the systems may be omitted. Connections of lines or connection members between elements shown in the drawings are illustrative of functional connections and/or physical or circuitry connections, and may be replaced in an actual device, or may be represented as additional various functional connections, physical connections, or circuitry connections.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

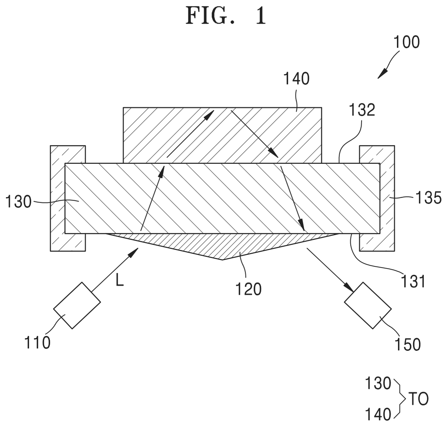

FIG. 1 schematically illustrates an optical system for metrology and inspection according to one or more embodiments.

An optical system 100 for metrology and inspection includes a light source 110 emitting light to a target object TO, an incidence angle adjuster 120 refracting light from the light source 110, and a photodetector 150 detecting light emitted through the target object TO.

The target object TO may include a substrate 130 and a subject 140 provided on the substrate 130. The substrate 130 may be, for example, an insulating substrate or a semiconductor substrate having an insulating layer formed on a surface thereof. As another example, the substrate 130 may be a semiconductor substrate. The semiconductor substrate may include at least one of, for example, silicon (Si), germanium (Ge), SiGe, or a group III-V semiconductor material. The substrate 130 may be, for example, a silicon substrate with silicon oxide formed on the surface thereof, but is not limited thereto.

The subject 140 may include, for example, a semiconductor device or an optical component having a three-dimensional (3D) nanostructure. The subject 140 may be include the substrate 130, but in the present specification, the remaining structure except for the substrate 130 is referred to as the subject 140. The subject 140 may be referred to as an object for which at least one of physical characteristics and optical characteristics is to be measured or a defect is to be inspected by using a metrology and inspection apparatus.

The substrate 130 may include a first surface 131 and a second surface 132 facing the first surface 131. The light source 110 may emit light toward the first surface 131 of the substrate 130. The incidence angle adjuster 120 may be provided on the first surface 131 of the substrate 130, and the subject 140 may be provided on the second surface 132. The subject 140 may include the 3D nanostructure. The 3D nanostructure may include various optical components, semiconductor components, and electronic components having nanometer-scale structures. For example, the subject 140 may include various types of couplers used in an augmented reality (AR) device, a virtual reality (VR) device, an extended reality (XR) device, etc., or structures for each process operation of manufacturing the couplers. As another example, the subject 140 may include various 3D memories such as 3D dynamic random access memory (DRAM), high bandwidth memory (HBM) memory, vertical not-AND (VNAND) flash memory, various integrated circuits, or structures for each process operation of manufacturing the 3D memories and the integrated circuits. The substrate 130 may be fixed by a holder 135. The holder 135 may include, for example, a glass or light-transmitting polymer, but is not limited thereto. In order to prevent or reduce reflection and scattering of light, anti-reflection coating may be further provided on a lower surface and an upper surface of the holder 135.

When a refractive index of the substrate 130 is n₁ and an effective refractive index of the subject 140 may be n₂, where n₁>n₂. In addition, the effective refractive index of the subject 140 and the refractive index of the substrate 130 may be greater than a refractive index of air, that is, 1. When the subject 140 does not include a single material but includes a plurality of components, and includes a plurality of materials, a refractive index of a material occupying the largest volume or the largest amount among the materials of the subject 140 is defined as the effective refractive index of the subject 140. For example, in the DRAM, when the subject 140 includes a plurality of transistors and a plurality of capacitors, and the volume of an silicon oxide (SiO₂) material among thee transistors and the capacitors is the largest, the effective refractive index of the subject 140 may be expressed as a refractive index of SiO₂. When the substrate 130 includes a plurality of layers, a refractive index of a material occupying the largest volume or the largest amount among the materials of the substrate 130 is defined as the refractive index of the substrate 130.

The light source 110 may have different emission wavelengths according to characteristics of the target object TO. For example, when the target object TO includes 3D memories or integrated circuits, the light source 110 may emit illumination light having a wavelength about 1.2 um or more and about 1.8 um or less. As another example, when the target object TO is an optical component used in an AR device, a VR device, or an XR device, the light source 110 may emit illumination light having a wavelength about 400 nm or more and about 1800 nm or less. The light source 110 may be configured to emit illumination light of a single wavelength, illumination light of a plurality of wavelengths, or illumination light in which wavelengths are distributed within a specific wavelength range. The light source 110 may include, for example, an LED or an LD. However, the light source 110 is not limited thereto.

A light L emitted from the light source 110 may be obliquely incident on the incidence angle adjuster 120. The incidence angle adjuster 120 may be disposed between the light source 110 and the substrate 130, and the light source 110 may emit light toward the first surface 131 of the substrate 130. The incidence angle adjuster 120 may be configured to adjust the incidence angle on the second surface 132 of the substrate 130 when the light L passes through the substrate 130 and is incident on the subject 140. The incidence angle adjuster 120 may include, for example, a prism. The incidence angle adjuster 120 may adjust an incidence angle of the light incident on the substrate 130 by refracting the light L. The incidence angle of the light incident on the subject 140 from the substrate 130 may vary according to the incidence angle of light incident on the substrate 130. For example, the prism may include at least one of borosilicate crown glass, fused silica, flint glass, or calcium fluoride (CaF₂). The incidence angle adjuster 120 may have a refractive index in a range greater than 1 and less than the refractive index of the substrate 130. In addition, the subject 140 may have the effective refractive index in a range greater than 1 and less than the refractive index of the substrate 130. When the incidence angle adjuster 120 includes a prism, the prism may have a refractive index in the range of, for example, 1.2 or more and 2.0 or less, or 1.3 or more and 1.8 or less.

The light incident on the subject 140 through the substrate 130 is reflected back toward the substrate 130 via the subject 140, passes through the substrate 130 and is emitted to the outside, and enters the photodetector 150. The photodetector 150 may convert the detected light into an electrical signal. The physical characteristics and the optical characteristics of the subject 140 may be measured and inspected by using a signal detected by the photodetector 150. With regard to a path of light, a point at which light is incident on the incidence angle adjuster 120 and a point at which light reflected from the subject 140 passes through the incidence angle adjuster 120 may be different from each other. In addition, the light source 110 and the photodetector 150 may be located in the same direction with respect to the substrate 130.

The photodetector 150 may include at least one of an image sensor or a spectrometer. For example, the spectrometer may be a spectroscopic ellipsometry. The photodetector 150 may include a hyperspectral image sensor. Light waves scattered after being incident on the subject 140 to be observed are captured by the photodetector 150, and then the structure of the subject 140 may be predicted by comparing a collected light wave signal with a predicted value of an optical simulation or database. The photodetector 150 may be configured to further detect at least one of a traveling angle or a polarization component as well as a wavelength component of incident light.

The optical system 100 for metrology and inspection may be configured to satisfy [Equation 1], [Equation 2], [Equation 3], and [Equation 4] below. [Equation 1] $C < A < B$ [Equation 2] $A = {n}_{1} \times sin \left({θ}_{1}\right) \times {k}_{0}$ [Equation 3] $B = {n}_{2} \times sin \left(90°\right) \times {k}_{0}$ [Equation 4] $C = {n}_{o} \times sin \left(90°\right) \times {k}_{0}$

[Equation 2] represents the transverse wavenumber of light incident on the first surface 131 of the substrate 130. n₁ denotes the refractive index of the substrate 130, and θ₁ denotes a refractive angle of light incident on the first surface 131 of the substrate 130. In addition, θ₁ may denote an incidence angle of light incident on the second surface 132 of the substrate 130. The angle θ₁ may thus denote the internal incidence angle of light at the interface between the substrate and the subject, measured within the substrate relative to the surface normal of that interface. Where light is refracted at the first surface of the substrate, θ₁ corresponds to the refracted angle inside the substrate and is therefore also the incidence angle at the second surface of the substrate. References to θ₁ as an "incidence angle" or a "refractive angle" may therefore be interchangeable within the context of the disclosed geometry and may refer to the same physical angle inside the substrate.

[Equation 3] represents the transverse wavenumber corresponding to a total reflection condition of the substrate 130 and a total reflection condition of the subject 140. n₂ represents the effective refractive index of the subject 140. Equation 4 represents the transverse wavenumber corresponding to total reflection of the substrate 130 and air. n₀ denotes a refractive index of air.

The incidence angle adjuster 120 may adjust an incidence angle θ₁ of light incident on the subject 140 from the substrate 130 to the subject 140 so that the optical system 100 for metrology and inspection according to one or more embodiments satisfies Equations 1 to 4. When the optical system 100 for metrology and inspection satisfies Equations 1 to 4, a path length of light passing through the subject 140 passes is long and the light does not escape to the outside of the subject 140, and thus an signal-to-noise ratio (SNR) of light waves for metrology of the subject 140 may be increased, and the precision and accuracy of metrology may be increased. Based on equations 1 to 4, in the optical system 100 for metrology and inspection, the transverse wavenumber of light passing through the incidence angle adjuster 120 may be greater than the transverse wavenumber corresponding to the total reflection of the substrate 130 and air, and may be less than the transverse wavenumber corresponding to the total reflection of the substrate 130 and the subject 140.

Further, [Equation 1-1] and [Equation 1-2] are satisfied: [Equation 1-1] ${n}_{0} < {n}_{1} \times sin \left({θ}_{1}\right) < {n}_{2}$ [Equation 1-2] $\left({n}_{0}/{n}_{1}\right) < sin \left({θ}_{1}\right) < \left({n}_{2}/{n}_{1}\right)$

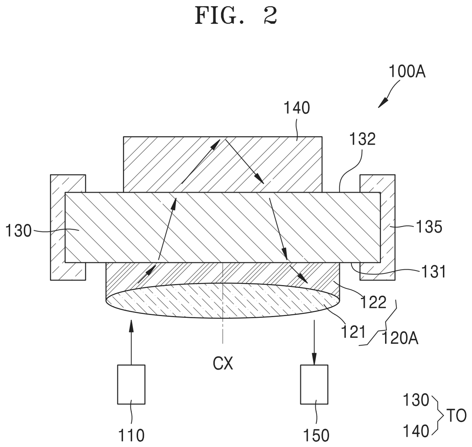

FIG. 2 illustrates an optical system for metrology and inspection according to one or more other embodiments. In FIG. 2, an incidence angle adjuster 120A is changed in comparison with FIG. 1. In FIG. 2, the components using the same reference numerals as in FIG. 1 are substantially the same as those described with reference to FIG. 1, and thus detailed descriptions thereof will be omitted and the differences will be mainly described.

An optical system 100A for metrology and inspection includes the light source 110 and the incidence angle adjuster 120A that causes and transmits light emitted from the light source 110 to be incident on the substrate 130.

The incidence angle adjuster 120A may include a lens 121 and an immersion medium 122 provided in the lens 121. The immersion medium 122 may be located between the lens 121 and the substrate 130, and completely filled in a space between the lens 121 and the substrate 130. The immersion medium 122 may include a liquid medium capable of reducing a difference between a refractive index of the lens 121 and a refractive index of the substrate 130. The resolution and brightness of an image may be improved by reducing the difference in the refractive index by light. The immersion medium 122 may include at least one of, for example, water, glycerol, cedarwood oil, synthetic immersion oil, bromoform, or carbon disulfide. The immersion medium 122 may have, for example, a refractive index in a range of 1.2 or more and 1.7.

In FIG. 2, light from the light source 110 may be incident on the lens 121, and the light may be incident on an edge of the lens 121 that is off a central axis CX of the lens 121. The light may be incident on the lens 121 in a direction parallel to the central axis CX of the lens 121. However, a path of light is not limited thereto, and the light may be obliquely incident on the lens 121. Then, the light passes through the substrate 130 and enters the subject 140, and the light totally reflected from the subject 140 passes through the substrate 130 and the lens 121 again via the inside of the subject 140 and enters the photodetector 150. The light entering the photodetector 150 may travel in the direction parallel to the central axis CX of the lens 121. A path of light from the light source 110 and a path of light entering the photodetector 150 may be symmetrical with respect to the central axis CX. A transverse wavenumber A of light incident on the second surface 132 of the substrate 130 by the incidence angle adjuster 120A may satisfy [Equation 1], [Equation 2], [Equation 3], and [Equation 4]. As such, the incidence angle adjuster 120A may be configured as an immersion type to adjust the transverse wavenumber A of the light incident on the second surface 132 of the substrate 130.

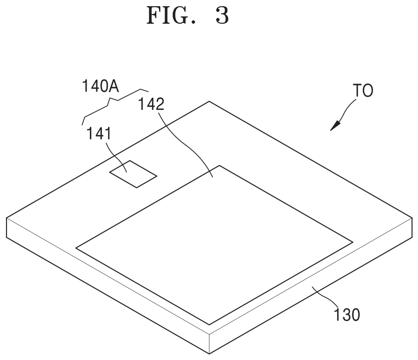

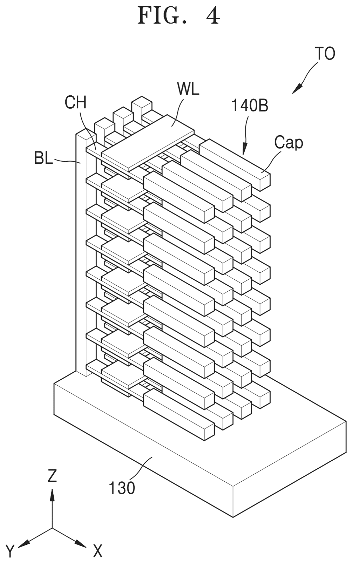

FIGS. 3 and 4 illustrate examples of the target object TO.

Referring to FIG. 3, the target object TO may include the substrate 130 and a subject 140A disposed on the substrate 130. The subject 140A may include an input coupler 141 provided on one side of the substrate 130 and an output coupler 142 on a second side of the substrate 130 and spaced apart from the input coupler 141. The substrate 130 may be a light guide plate having relatively high transmittance to visible light. The input coupler 141 may serve to couple light input from the outside to the inside of the substrate 130. The output coupler 142 may serve to emit light propagated from the inside of the substrate 130 to the outside of the substrate 130, for example, the user's eyes. The input coupler 141 and the output coupler 142 may each include a 3D nanostructure having a nanoscale lattice structure disposed at intervals of several tens to several hundreds of nm.

Referring to FIG. 4, the target object TO may include the substrate 130 and a subject 140B provided on the substrate 130. In this case, the substrate 130 may be a semiconductor wafer. The subject 140B may have a 3D nanostructure including nanoscale electronic components such as various wirings, field effect transistors, capacitors, etc. having a size of several nm to hundreds of nm. The subject 140B may be a vertical stack memory device.

The subject 140B may include a plurality of bit lines BL extending in a first direction (i.e., Z direction), a plurality of channels CH respectively connected to the plurality of bit lines BL and extending in a second direction (i.e., X direction) perpendicular to the first direction, a plurality of capacitors Cap respectively electrically connected to the plurality of channels CH, and a plurality of word lines WL extending to cross the plurality of channels CH in a third direction (i.e., Y direction) perpendicular to the first direction and the second direction. The word line WL may correspond to a gate electrode. The channel CH may be, for example, an oxide including at least one of indium (In), gallium (Ga), zinc (Zn), tungsten (W), tin (Sn), or hafnium (Hf). The channel CH may include, for example, zinc indium oxide (ZIO), indium gallium oxide (IGO), or indium gallium zinc oxide (IGZO). The channel CH may include InGaZnO, ZrInZnO, InGaZnO₄, ZnInO, In₂O₃, HfInZnO, or a combination thereof. However, the channel CH is not limited thereto.

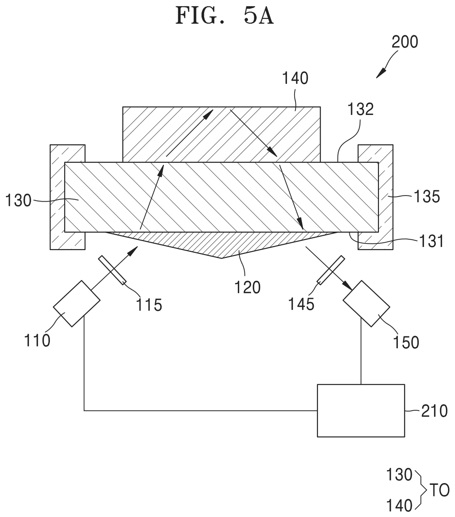

FIG. 5A illustrates a metrology and inspection apparatus according to one or more embodiments.

A metrology and inspection apparatus 200 includes the substrate 130, the light source 110 emitting light to the target object TO including the subject 140 provided on the substrate 130, the incidence angle adjuster 120 refracting light from the light source 110, the photodetector 150 detecting light emitted through the target object TO, and a processor 210 controlling operations of the light source 110 and the photodetector 150 and analyzing the subject 140 based on an output of the photodetector 150. In FIG. 5A, the components using the same reference numerals as in FIG. 1 have substantially the same configurations and operations, and thus detailed descriptions thereof will be omitted. FIG. 5A shows an example in which the incidence angle adjuster 120 is implemented as an optical coupler such as a prism.

The processor 210 may control the light source 110 to adjust a wavelength, polarization, azimuthal angle, and an incidence angle of light incident on the incidence angle adjuster 120, etc. The processor 210 may calculate and/or obtain an appropriate incidence angle of light satisfying [Equation 1], [Equation 2], [Equation 3], and [Equation 4] based on the wavelength, polarization, azimuthal angle, incidence angle, etc. of light. To this end, the processor 210 may include at least one of data about the incidence angle adjuster 120, for example, data such as a refractive index and a peak angle of a prism, or data such as a refractive index and a thickness of the substrate 130, a refractive index and a thickness of the subject 140, and the wavelength, polarization, azimuthal angle, and incidence angle of light. The processor 210 may include a data input/output device and a memory inputting and recording the above-described data. The processor 210 may measure various physical characteristics and optical characteristics at the same position of the subject 140 by adjusting at least one of the wavelength, polarization, azimuthal angle, or incidence angle of light.

The processor 210 may analyze the subject 140 of the target object TO based on a signal provided from the photodetector 150, for example, optical critical dimension measurement and/or spectroscopic ellipsometry. The optical critical dimension measurement may measure, for example, a critical dimension of a semiconductor pattern in a non-contact manner.

After a photolithography process or an etching process, the optical critical dimension measurement may measure dimensions of a microstructure such as a line width and a space between patterns on a mask or a wafer. The dimension or shape of the subject 140 may be back-calculated by emitting light of a specific wavelength to the subject 140 and analyzing the intensity and phase of the light reflected or diffracted from the subject 140. The processor 210 may be implemented as a dedicated integrated circuit chip, or may be implemented as a programmable logic controller (PLC) configured to execute analysis software.

A first polarization filter 115 may be disposed between the light source 110 and the incidence angle adjuster 120. The first polarization filter 115 may adjust a polarization component of light emitted from the light source 110. The first polarization filter 115 may adjust the polarization component of light from the light source 110 to measure polarization characteristics of the subject 140. A second polarization filter 145 may be disposed between the incidence angle adjuster 120 and the photodetector 150. The second polarization filter 145 may reduce noise by filtering a polarization component of light emitted through the subject 140.

The metrology and inspection apparatus 200 according to one or more embodiments increases the path length of light by emitting light to the opposite surface of the second surface 132 of the substrate 130 including the subject 140, that is, the first surface 131 so that the light is totally reflected from an upper surface of the subject 140, and thus the light may pass long over the entire thickness of a 3D structure of the subject 140 even though the total thickness of the 3D structure is great. In addition, the light incident on the subject 140 has an increased wavenumber in a horizontal direction, by adjusting the incidence angle of light by using the incidence angle adjuster 120 provided on the rear surface of the substrate 130, that is, the first surface 131, and thus the subject 140 may be measured and inspected at higher resolution and a relatively high SNR.

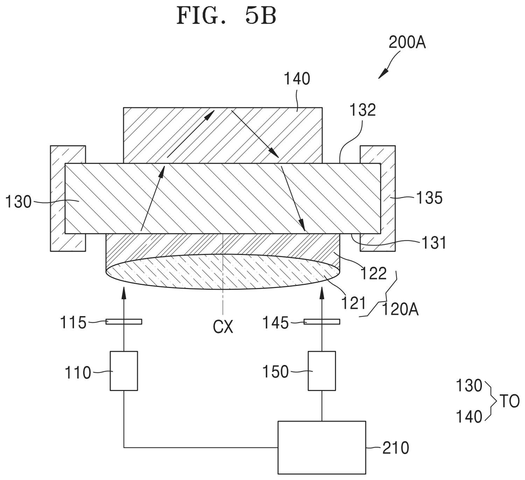

FIG. 5B illustrates a metrology and inspection apparatus 200A according to one or more other embodiments. In comparison with FIG. 5A, the incidence angle adjuster 120A is different from the angle adjuster 120, and the differences will be mainly described with reference to FIG. 5B. The metrology and inspection apparatus 200A may include the immersion type incidence angle adjuster 120A. The incidence angle adjuster 120A may include the lens 121 and the immersion medium 122 provided in the lens 121. A transverse wavenumber of light incident on the substrate 130 through the incidence angle adjuster 120A may be greater than a transverse wavenumber corresponding to total reflection of air and the substrate 130 and less than a transverse wavenumber corresponding to total reflection of the substrate 130 and the subject 140.

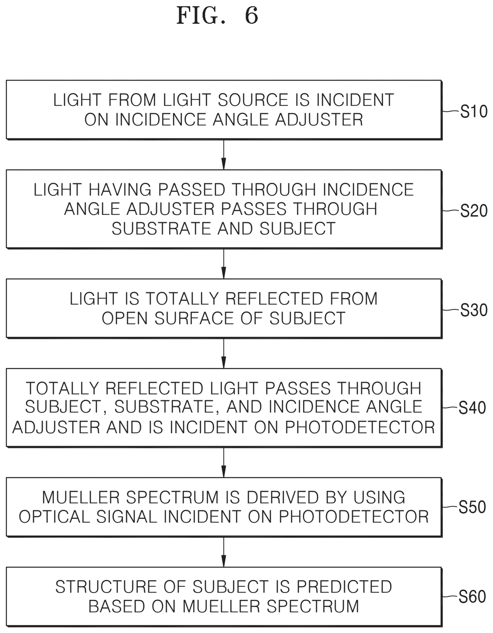

FIG. 6 is a diagram for explaining a metrology and inspection method according to one or more embodiments.

Referring to FIGS. 6, 5A, and 5B, light from the light source 110 is incident on the incidence angle adjuster 120 (S10). The processor 210 may adjust the incidence angle of light incident on the incidence angle adjuster 120 by adjusting the light source 110. The processor 210 may adjust the transverse wavenumber A of light incident on the substrate 130 to be greater than a transverse wavenumber C corresponding to the total reflection of the substrate 130 and air, and to be less than a transverse wavenumber B corresponding to the total reflection of the substrate 130 and the subject 140 through the incidence angle adjuster 120. Then, the light passing through the incidence angle adjuster 120 passes through the substrate 130 and the subject 140 (S20). The light is totally reflected from an open surface of the subject 140 by satisfying the above conditions (S30). The open surface may represent a surface on which the subject 140 is in contact with air. Then, the light passes through the subject 140, the substrate 130, and the incidence angle adjuster 120 and is incident on the photodetector 150 (S40). Then, a Mueller spectrum may be derived by using an optical signal incident on the photodetector 150 (S50). The structure of the subject 140 may be predicted and/or estimated based on the Mueller spectrum (S60).

As described above, the light passing through the subject 140 at a greatest amount possible may be input to the photodetector 150, and the processor 210 may analyze a signal output from the photodetector 150 to more precisely measure and inspect at least one of the physical characteristics and optical characteristics of the subject 140.

Next, the operation and effect of the optical system for metrology and inspection according to one or more embodiments will be described.

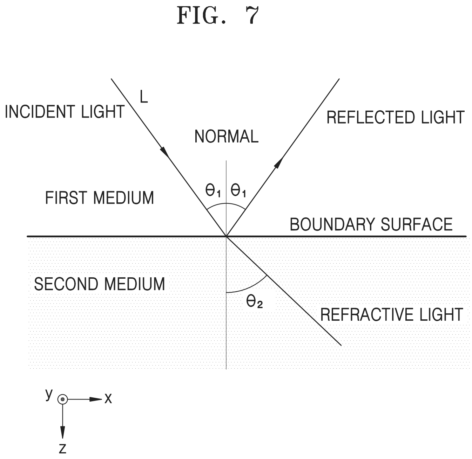

FIG. 7 shows that when the light L passes through two media having different refractive indices, the light L is partially reflected and partially refracted at a boundary between the two media. θ₁ denotes an incidence angle and a reflection angle, and θ₂ denotes a refraction angle. When there is a boundary along an x-y plane perpendicular to the z-direction, an x-z plane is a plane of incidence, and the normal is a line perpendicular to the x-y plane and has a (+z) direction and a (-z) direction. Transverse waves or s waves represent light waves in which an electric field is perpendicular to an incident surface, and longitudinal waves or p waves represent light waves in which the electric field is parallel to the incident surface.

A wavenumber k in a medium having a refractive index n satisfies [Equation 5] below. [Equation 5] $k = 2 πn / λ 0$

Here, λ₀ denotes a wavelength in the vacuum or air.

A horizontal component of light waves in a first medium with the refractive index n₁, that is, the transverse wavenumber, is k₁sinθ₁, and a horizontal component of light waves in a second medium with the refractive index n₂, that is, k₂sinθ₂. Here, the horizontal component of the wavenumber is preserved at the boundary between the two media, and thus [Equation 6] below is satisfied. [Equation 6] ${k}_{1} sin {θ}_{1} = {k}_{2} sin {θ}_{2}$

Here, k₁=2πn₁/λ₀ and k₂=2πn₂/λ₀ according to [Equation 5], and are substituted into [Equation 6] as shown in [Equation 7] as follows. [Equation 7] $\left(2{πn}_{1}/{λ}_{0}\right) sin {θ}_{1} = \left(2{πn}_{2}/{λ}_{0}\right) sin {θ}_{2}$

[Equation 7] is summarized as shown in [Equation 8] as follows. [Equation 8] ${n}_{1} sin {θ}_{1} = {n}_{2} sin {θ}_{2}$

[Equation 8] represents the Snell's law. The conditions for total reflection may be obtained from the Snell's law. Total reflection shows a phenomenon that when light waves are incident from a medium with a higher refractive index to a medium with a lower refractive index, light waves with an incidence angle greater than a specific angle are totally reflected. With regard to the first medium having the refractive index n₁ and the second medium having the refractive index n₂, n₁ > n₂, and when light waves are incident from the first medium to the second medium, θ₁ < θ₂. In addition, when θ₁ has an angle greater than a specific angle, θ₂ becomes greater than 90 degrees, and thus total reflection occurs that the incident light waves are totally reflected. The specific angle is called a critical angle. According to [Equation 6], for total reflection of light, θ₁ < θ₂, and k1 > k2. When the total reflection conditions are satisfied, light waves are totally reflected in the first medium without exiting the second medium, and the path length of light in the first medium is increased, thereby increasing the SNR when measuring physical characteristics and/or optical characteristics of the first medium and increasing metrology precision.

The optical system 100 for metrology and inspection according to one or more embodiments may be configured such that the wavenumber of light incident on the substrate 130 is greater than the wavenumber in the transverse (x-direction) corresponding to the total reflection conditions of air and the subject 140 and less than the wavenumber in the transverse (x-direction) corresponding to the total reflection conditions of the substrate 130 and the subject 140. As a result, the SNR to light may be increased by increasing the path length of light passing through the subject 140, and increasing the amount of light received by the photodetector 150 by being totally reflected from the subject 140. In addition, even though the thickness of the subject 140 increases, light passes through the path of the entire thickness of the subject 140 and thus precise metrology may be possible.

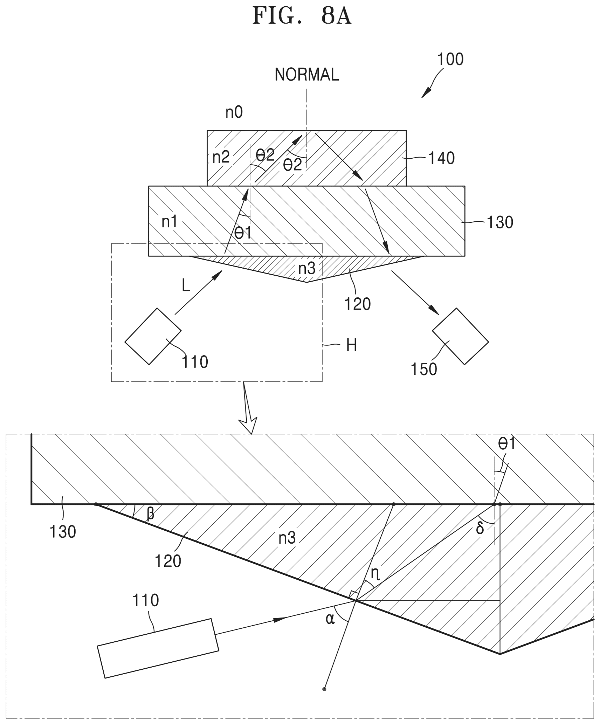

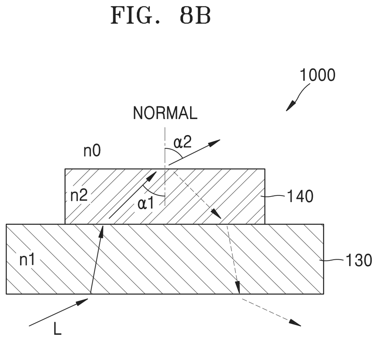

FIG. 8A illustrates an incidence angle, a refraction, and a reflection path of light in the optical system 100 for metrology and inspection according to one or more other embodiments. FIG. 8B illustrates an incidence angle, a refraction, and a reflection path of light in an optical system 1000 of a related example.

The optical system 100 for metrology and inspection may be configured to satisfy [Equation 1], [Equation 2], [Equation 3], and [Equation 4].

For example, when the subject 140 is a 3D semiconductor device, in a case where the layer number of 3D semiconductor devices increases, it is necessary for light waves to be used for metrology and inspection to interact with the 3D semiconductor device at a greatest amount possible rather than reducing the reflectivity of p waves. To this end, the incidence angle adjuster 120 may be provided on the first surface 131 of the substrate 130, and may guide light waves to have a transverse wavenumber that satisfies [Equation 1], [Equation 2], [Equation 3], and [Equation 4] and be incident on the first surface 131 of the substrate 130.

When the transverse wavenumber A of light incident on the substrate 130 through the incidence angle adjuster 120 is less than the transverse wavenumber B corresponding to the total reflection of the substrate 130 and the subject 140, light waves enter the subject 140 from the substrate 130. In addition, when A is greater than a transverse wavenumber C corresponding to the total reflection of the substrate 130 and air, light may not escape to air due to the total reflection. The light that may not escape to air passes through the subject 140 and the substrate 130 again and enters the photodetector 150.

Referring to a magnification part of FIG. 8A, when light from the light source 110 is incident on the incidence angle adjuster 120, in case where an incidence angle with respect to the incidence angle adjuster 120 is α, and a refraction angle with respect to the incidence angle adjuster 120 is η, the following [Equation 9] is satisfied according to the Snell's law. ${n}_{0} sinα = {n}_{3} sin η$ [Equation 9] $η = {sin}^{- 1} \left(\left({n}_{0}/{n}_{3}\right)sin α\right)$

Here, n₃ denotes a refractive index of the incidence angle adjuster 120.

When an apex angle at which the incidence angle adjuster 120 meets the substrate 130 is β, an incidence angle δ of light entering the substrate 130 from the incidence angle adjuster 120 satisfies [Equation 10] as follows. [Equation 10] $δ = β + η$

In addition, the light incident from the incidence angle adjuster 120 to the substrate 130 satisfies the following [Equation 11] according to the Snell's law. [Equation 11] ${n}_{3} sin δ = {n}_{1} sin {θ}_{1}$

The refractive angle θ₁ of the first surface 131 of the first substrate 130 or the incidence angle θ₁ of the second surface 132 satisfies [Equation 12] by summarizing [Equation 9], [Equation 10], and [Equation 11] is as follows. <Equation 12> $\begin{matrix}sin {θ}_{1} = \left({n}_{3}/{n}_{1}\right) sin δ \\ = \left({n}_{3}/{n}_{1}\right) sin \left(β+η\right) \\ = \left({n}_{3}/{n}_{1}\right) sin \left(β+{sin}^{- 1}\left(\left({n}_{0}/{n}_{3}\right)sin α\right)\right)\end{matrix}$

Based on [Equation 12], θ₁ may be adjusted by adjusting the refractive index n₃, the apex angle β, and the incidence angle α of the incidence angle adjuster 120.

The metrology and inspection apparatus 100 according to one or more embodiments may increase the path length of light of the subject 140 by making the transverse wavenumber A of light incident on the substrate 130 greater than the transverse wavenumber C corresponding to the total reflection of the substrate 130 and making the transverse wavenumber A less than the transverse wavenumber B corresponding to the total reflection of the substrate 130 and the subject 140 through the incidence angle adjuster 120.

Next, referring to FIG. 8B, the metrology and inspection apparatus 1000 of the related example causes light L1 to be directly incident on the substrate 130 without an incidence angle adjuster. The light incident on the subject 140 is partially refracted from an upper surface of the subject 140 and goes out, and partially reflected into the subject 140. When an incidence angle of light incident on the upper surface of the subject 140 is α1, and a refractive angle of the refracted light is α2, α1 <α2. In the related example, a transverse wavenumber of light incident on the substrate 130 does not satisfy [Equation 1], [Equation 2], [Equation 3], and [Equation 4].

Hereinafter, the effects of the one or more embodiment and the related example will be compared and described.

According to one or more embodiments, the incidence angle adjuster 120 may adjust the incidence angle θ₁ on the first surface 131 of the substrate 130, and thus light waves to be used for metrology and inspection may interact with the subject 140 at a greatest amount possible. As a result, even for a relatively minor change in the characteristics to be measured by the subject 140, such as a 3D semiconductor device or an optical component, a signal with higher reliability may be obtained, and a higher SNR may be provided, thereby increasing the metrological power of a deep portion.

For example, when the subject 140 is a 3D semiconductor device, the substrate 130 may be a silicon substrate, and the subject 140 may include a transistor and a capacitor. The transistor and the capacitor may include various materials. For example, SiO₂ may be a material that occupies the largest amount, and in this case, the effective refractive index n₂ of the subject 140 may be defined as a refractive index of SiO₂, and [Equation 1], [Equation 2], [Equation 3], and [Equation 4] may be applied.

The Mueller spectrum when a specific metrology object changes in a 3D semiconductor device by using optical simulation will be described.

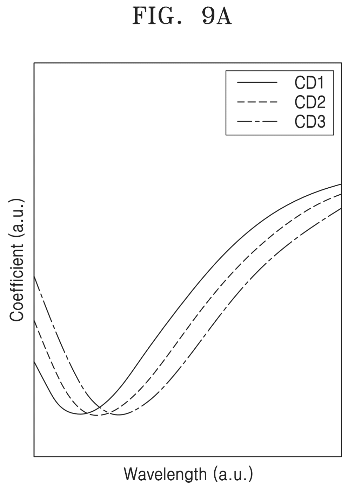

FIG. 9A illustrates the Mueller spectrum of an optical system for metrology and inspection according to one or more embodiments.

FIG. 9A shows coefficients according to wavelengths with respect to examples configured to satisfy the relationship between C < A < B by using the incidence angle adjuster 120 in one or more embodiments. Here, the coefficient may exhibit optical characteristics such as polarization-dependent absorption, scattering, refraction, etc. CD1, CD2, and CD3 represent samples in which an incidence angle and a refractive index of light are changed. In this case, light waves do not travel toward air, but are reflected at an interface between the subject 140 and air, and interact with the subject 140 at a greatest amount possible while passing through the inside of the subject 140. In this case, when the Mueller spectrum is derived through 3D optical simulation with respect to a case where a value of the specific metrology object among 3D semiconductor products changes, a distinguishable spectrum is obtained as shown in FIG. 9A. The Mueller spectrum is a quantitative representation of the polarization characteristics of the subject 140 such as a nanostructure, and is spectrum data obtained by measuring a Mueller matrix component for each wavelength. Accordingly, the characteristics such as polarization-dependent absorption, scattering, and refraction of the subject 140 may be analyzed. The larger the space of the spectra of each of the samples CD1, CD2, and CD3, the higher the metrological power of the subject 140.

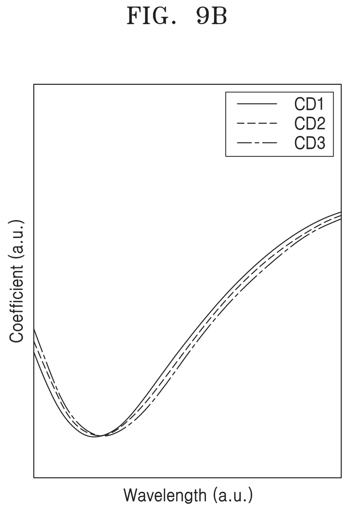

FIG. 9B shows the Mueller spectrum with respect to the related example without the incidence angle adjuster 120, and in this case, light is directly incident on the substrate 130 in air, A < C < B, and thus light waves may be lost into air. In this case, when the Mueller spectrum is derived through 3D optical simulation, the space of the spectra is relatively reduced as shown in FIG. 9B, which makes it difficult to distinguish the spectra.

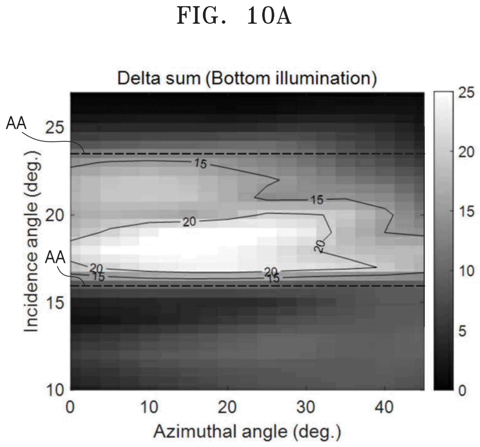

FIG. 10A illustrates the sum of differences in spectra according to a change in a metrology object shown in FIG. 9A with respect to various incidence angles and azimuthal angles. In FIG. 10A, a horizontal axis represents an azimuthal angle, and a vertical axis represents an incidence angle with respect to a normal on the substrate 130. A scale represents an average value of absolute values of differences between a spectrum when a structure of the metrology object is the smallest and a spectrum when the structure of the metrology object is the largest within a predetermined range. The greater the value, the greater the degree to which the spectrum is distinguished, the more the valid information data, and the higher the accuracy of metrology results.

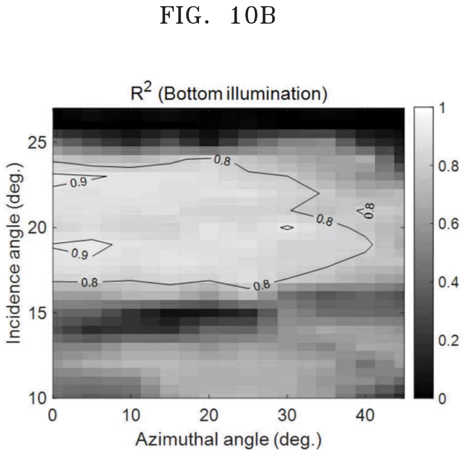

FIG. 10B illustrates the sum of differences in spectra according to a change in a metrology object shown in FIG. 9B with respect to various incidence angles and azimuthal angles.

FIG. 10A shows regions having a scale value of 15 or more, whereas FIG. 10B shows regions having a scale value of less than 1. This shows that the accuracy of metrology on the subject 140 of a 3D nanostructure may be increased by ensuring that the relationship of C < A < B is satisfied in the optical system according to one or more embodiments.

FIGS. 10A and 10B show results of examples in which the substrate 130 is a silicon substrate and the subject 140 includes SiO2 by substituting refractive indices of silicon and SiO₂ into Equation 10. A refractive index of air is 1, a refractive index of Si is about 3.5, and a refractive index n_{SiO2} of SiO₂ is about 1.46, and these values may be substituted into [Equation 1] and [Equation 2] to satisfy [Equation 13] and [Equation 14] below. [Equation 13] $\left(1/3.5\right) < sin \left({θ}_{1}\right) < \left(1.46/3.5\right)$ [Equation 14] $16.6 ° < {θ}_{1} < 24.6 °$

In FIG. 10A, an incidence angle range of a region with a scale value of 15 or more is indicated by an auxiliary line AA. The incidence angle range of the auxiliary line AA is approximately 16 ° to 24 °. According to this, it may be seen that a period showing a relatively high spectrum difference in which the scale value is 15 or more is within the incidence angle range of [Equation 14]. This shows that the accuracy of metrology is relatively high when the metrology and inspection apparatus according to the embodiment satisfies [Equation 1], [Equation 2], [Equation 3], and [Equation 4].

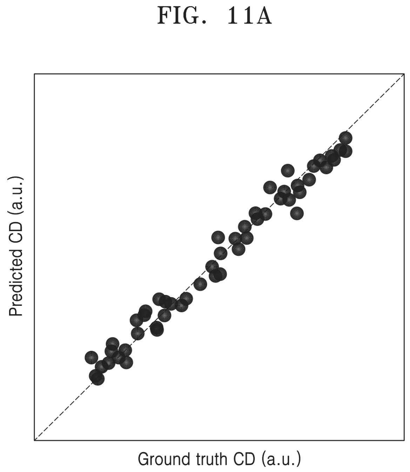

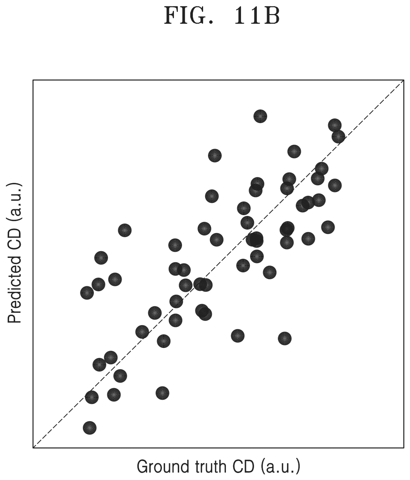

FIGS. 11A and 11B show a comparison of results of testing whether predictive power or metrological power is improved in a relatively high scale period, assuming that there is noise in the Mueller spectrum with respect to one or more embodiments and a related example, respectively.

FIG. 11A shows the result of test under the condition of 16.6° < θ₁ = 19° < 24.6° to satisfy C < A < B with respect to an azimuthal angle of 0°. In FIG. 11A, the horizontal axis represents a ground truth critical dimension (CD), and the vertical axis represents an expected CD value when noise is added to the spectrum. The ground truth CD may represent a CD which is a true value with respect to the actual dimension of a semiconductor pattern. In the graph, the closer the data value is to a diagonal, the higher a correlation R² between the true value and the predicted value, indicating that the reliability of the predicted value is relatively high. In this case, the correlation R² between the true value and the predicted value is relatively high at about 0.904. This shows that an SNR is improved, and thus prediction accuracy is improved.

FIG. 11B shows the related example having a condition of A < C with respect to azimuthal angle of 0°, and θ₁ =15° < 16.6°. In comparison with FIG. 11A, FIG. 11B shows that data values are distributed relatively widely on the diagonal. In this case, the correlation R² between the true value and the predicted value is approximately 0.413 which is relatively low.

As described above, the optical system 100 for metrology and inspection and the metrology and inspection apparatus 200 according to one or more embodiments are configured to satisfy [Equation 1], [Equation 2], [Equation 3], and [Equation 4], thereby increasing the SNR by increasing the path length of light passing through the subject 140 and increasing the metrology accuracy.

The optical system 100 for metrology and inspection and the metrology and inspection apparatus 200 according to one or more embodiments may allow light to reach deep portions of various subjects 140 having a 3D nanostructure with a relatively high number of layers and increasing the path length of light, thereby accurately performing metrology and inspection on the optical characteristics and physical characteristics of the subjects 140. The light incident on the substrate 130 through the incidence angle adjuster 120 may interact with the subject 140 at a greatest amount possible, thereby showing a relatively large amount of signal even for a minor structural change. This may enable a relatively high SNR to perform prediction close to a true value, and increase the metrological power with respect to a deep region of the substrate 140, such as a 3D semiconductor.

The optical system for metrology and inspection according to one or more embodiments may increase the path length of light passing through a subject to allow light to reach a deep portion of the subject, and accordingly, thereby more accurately performing metrology and inspection on at least one of the optical characteristics or the physical characteristics of the subject even when the height or the thickness of the subject increases.

It should be understood that embodiments described herein should be considered in a descriptive sense only and not for purposes of limitation.

For example, the numerical incidence angle range disclosed herein (for example, 16.6° < θ₁ < 24.6°) is derived from a representative material system comprising a silicon substrate and a subject having an effective refractive index corresponding to silicon dioxide. It will be understood by the skilled person that different material systems will result in different numerical angle ranges while satisfying the same underlying transverse wavenumber relationship.

Descriptions of features or aspects within each embodiment should typically be considered as available for other similar features or aspects in other embodiments. While embodiments have been described with reference to the figures, it will be understood by those of ordinary skill in the art that various changes in form and details may be made therein without departing from the scope as defined by the following claims and their equivalents.

## Claims

1. An optical system for metrology and inspection, the optical system comprising:
a substrate comprising a first surface and a second surface facing the first surface;
a light source configured to emit light toward the first surface of the substrate with respect to a subject on the second surface of the substrate;
an incidence angle adjuster on the first surface of the substrate; and
a photodetector configured to detect light having passed through the substrate and the subject and emitted through the first surface of the substrate,
wherein a wavenumber of light incident on the substrate is greater than a transverse wavenumber corresponding to a total reflection condition of air and a total reflection condition of the substrate, and is less than a transverse wavenumber corresponding to the total reflection condition of the substrate and a total reflection condition of the subject.

2. The optical system of claim 1, wherein a refractive index of the substrate is greater than an effective refractive index of the subject, and the effective refractive index of the subject is greater than 1.

3. The optical system of claim 2, wherein the incidence angle adjuster comprises a prism, and a refractive index of the prism is less than the refractive index of the substrate.

4. The optical system of any preceding claim, wherein the incidence angle adjuster is configured such that an incidence angle θ₁ of light incident on the subject from the substrate satisfies 16.6° < θ₁ < 24.6°.

5. The optical system of any preceding claim, wherein the incidence angle adjuster comprises a prism, and a refractive index of the prism is greater than or equal to 1.4 less than or equal to 1.8.

6. The optical system of claim 5, wherein the prism comprises at least one of borosilicate crown glass, molten silica, flint glass, or calcium fluoride (CaF₂).

7. The optical system of claim 5 or 6, wherein an apex angle of the prism is greater than or equal to 10 degrees and less than or equal to 45.

8. The optical system of any preceding claim, wherein the incidence angle adjuster comprises a lens and an immersion medium included in the lens, and optionally wherein a refractive index of the immersion medium is greater than or equal to 1.2 and less than or equal to 1.7.

9. The optical system of any preceding claim, wherein a point where light is incident on the incidence angle adjuster is different from a point where light reflected from the subject passes through the incidence angle adjuster.

10. A metrology and inspection apparatus comprising:
an optical system for metrology and inspection according to any preceding claim; and
a processor configured to control an operation of the light source and the photodetector and, based on an output of the photodetector, analyze the subject,

11. The metrology and inspection apparatus of claim 10, further comprising:
a first polarization filter between the light source and the incidence angle adjuster.

12. The metrology and inspection apparatus of claim 10 or 11, further comprising:
a second polarization filter between the incidence angle adjuster and the photodetector.

13. A metrology and inspection method on a target object comprising a substrate comprising a first surface and a second surface facing the first surface and a subject on the second surface of the substrate, the metrology and inspection method comprising:
emitting light by the light source to an incidence angle adjuster;
transmitting light, having passed through the incidence angle adjuster, through the substrate and a subject;
totally reflecting the light, transmitted through the substrate and the subject, from a surface of the subject;
transmitting the light, totally reflected, through the subject, the substrate, and the incidence angle adjuster and be incident on the photodetector;
obtaining a Mueller spectrum based on an optical signal incident on the photodetector; and
estimating a structure of the subject based on the Mueller spectrum.

14. The metrology and inspection method of claim 13, wherein a refractive index of the substrate is greater than an effective refractive index of the subject, and the effective refractive index of the subject is greater than 1.

15. The metrology and inspection method of claim 13 or 14, wherein the incidence angle adjuster comprises a prism, and a refractive index of the prism is less than the refractive index of the substrate.
